# EUROPEAN PATENT APPLICATION

(11) **EP 4 336 975 A2**
(43) Date of publication of application: **13.03.2024**
(21) Application number: 23191925.9
(22) Date of filing: 17.08.2023
(51) Int. Cl.: H05K 1/02, H05K 3/34

(54) **CIRCUIT BOARD ASSEMBLY AND ELECTRONIC DEVICE**

(30) Priority: 17.08.2022 CN 202210986834
(71) Applicant: Huawei Digital Power Technologies Co., Ltd., Shenzhen, Guangdong 518043 (CN)
(72) Inventor: TAO, Wei, Shenzhen, 518043 (CN); WANG, Yuchuan, Shenzhen, 518043 (CN); TANG, Qingguo, Shenzhen, 518043 (CN); LIU, Wutao, Shenzhen, 518043 (CN); XU, Shuguang, Shenzhen, 518043 (CN)
(74) Representative: Gill Jennings & Every LLP

(57) **Abstract**

This application relates to the field of electronic device technologies, and provides a circuit board assembly and an electronic device, to resolve a problem that a circuit board assembly has poor current-carrying performance and is not easy to manufacture. The circuit board assembly provided in this application may include a circuit board and a conductive plate. The circuit board includes a substrate and a conductive trace. The conductive trace is disposed on the substrate. The conductive plate is fastened in a first region of the circuit board, and a current-carrying capacity of the conductive plate is greater than that of the conductive trace. In the circuit board assembly provided in this application, the conductive plate capable of carrying a relatively large operating current is provided to significantly improve a current-carrying capability of the circuit board assembly, so that the circuit board assembly can be applied to a scenario requiring a relatively large current; and the conductive plate and the circuit board are manufactured separately, and then, the conductive plate is disposed in the first region of the circuit board, to implement a fastened connection between the conductive plate and the circuit board. Therefore, manufacturing costs and process difficulty are reduced, and low-cost and batch manufacturing is implemented.

## Description

### TECHNICAL FIELD

This application relates to the field of electronic device technologies, and in particular, to a circuit board assembly and an electronic device.

### BACKGROUND

An electronic device usually includes a plurality of electronic components of different types and functions, such as a relay and an inductor, and the plurality of electronic components may be disposed on a printed circuit board (PCB) to implement power supply and signal transmission.

With the continuous development of technologies, power density of some electronic components is significantly improved, and operating currents required by the electronic components are accordingly increased. In a current PCB, to carry a relatively large operating current, a quantity of PCB layers or a thickness of a copper layer is usually increased to improve a current flow capability. However, this increases thickness of the PCB, which goes beyond a capability range of current PCB manufacturing and assembly processes. In addition, machining difficulty and costs are also significantly increased, which is not conducive to actual application.

### SUMMARY

This application provides a circuit board assembly that may carry a relatively large current and is easy to manufacture, and an electronic device.

According to a first aspect, this application provides a circuit board assembly, including a circuit board and a conductive plate. The circuit board includes a substrate and a conductive trace. The conductive trace is disposed on the substrate. The conductive plate is fastened in a first region of the circuit board, and a current-carrying capacity of the conductive plate is greater than that of the conductive trace. In the circuit board assembly provided in this application, the conductive plate capable of carrying a relatively large operating current is provided to significantly improve a current-carrying capability of the circuit board assembly, so that the circuit board assembly can be applied to a scenario requiring a relatively large current; and the conductive plate and the circuit board are manufactured separately, and then, the conductive plate is disposed in the first region of the circuit board, to implement a fastened connection between the conductive plate and the circuit board. Therefore, manufacturing costs and process difficulty are reduced, and low-cost and batch manufacturing is implemented.

During specific configuration, the circuit board is provided with a first surface and a second surface that are disposed opposite to each other, and the first region may be a portion of the first surface or of the second surface. In other words, the conductive plate may be disposed on the first surface or the second surface. Certainly, in some examples, the conductive plate may be disposed on both the first surface and the second surface.

In an example, the conductive plate may be fastened in the first region through a dielectric layer, so that the fastened connection between the conductive plate and the circuit board can be implemented. During manufacturing, a press-fitting process may be used to effectively reduce the manufacturing costs. This facilitates implementation of large-scale and batch production.

A material of the dielectric layer may be an insulator.

In an example, a conductive connection between the conductive trace in the circuit board and the conductive plate may be implemented through a plated through hole. The plated through hole may pass through the dielectric layer, and the plated through hole is electrically connected to the conductive trace and the conductive plate, to implement the electrical connection between the circuit board and the conductive plate.

Alternatively, the dielectric layer may include a conductive material, so that the dielectric layer has a relatively good conductive capability. In an example, the conductive trace may extend to the first region, and the dielectric layer is electrically connected to the conductive plate and the conductive trace. In other words, the fastened connection and the electrical connection between the conductive plate and the circuit board may be implemented through the dielectric layer. This may facilitate convenience of manufacturing, and help simplify a preparation procedure.

In an example, the circuit board is provided with a groove, and the first region is a bottom of the groove. The conductive plate is embedded in the groove, so that a thickness in which the electronic component is mounted may be disposed in the circuit board, where the jack is located outside the first region. In other words, the conductive plate does not cover the jack. This avoids an adverse impact such as interference on assembly of the electronic component.

In addition, during specific configuration, the conductive plate may be a plate body, or may include a plurality of sub-plate bodies. The plurality of sub-plate bodies are spaced apart from each other. A thickness of each sub-plate body may be greater than or equal to 0.3 mm, so that the corresponding sub-plate body has a good current-carrying capability.

According to a second aspect, this application further provides an electronic device, where the electronic device may include a housing and any one of the foregoing circuit board assemblies. The circuit board assembly may be fastened in the housing. The foregoing circuit board assembly is used, so that a demand of the electronic device for a relatively large current-carrying capability is met. In addition, because the circuit board assembly requires a relatively low manufacturing process, structural reliability of the circuit board assembly can be ensured, thereby ensuring working stability of the electronic device.

During specific configuration, the electronic device may be a photovoltaic device, an energy storage device, a charging pile, or the like. A specific type of the electronic device is not limited in this application.

### BRIEF DESCRIPTION OF DRAWINGS

FIG. 1 is a block diagram of a structure of a photovoltaic device according to an embodiment of this application;
FIG. 2 is a schematic diagram of a cross-section structure of a circuit board assembly according to an embodiment of this application;
FIG. 3 is a schematic diagram of a cross-section structure of another circuit board assembly according to an embodiment of this application;
FIG. 4 is a schematic diagram of a cross-section structure of a circuit board assembly according to an embodiment of this application;
FIG. 5 is a top view of another circuit board assembly according to an embodiment of this application;
FIG. 6 is a schematic diagram of a cross-section structure of a circuit board assembly according to an embodiment of this application;
FIG. 7 is a schematic diagram of a cross-section structure of another circuit board assembly according to an embodiment of this application;
FIG. 8 is a schematic diagram of a cross-section structure of another circuit board assembly according to an embodiment of this application;
FIG. 9 is a schematic diagram of a cross-section structure of another circuit board assembly according to an embodiment of this application;
FIG. 10 is a schematic diagram of a cross-section structure of another circuit board assembly according to an embodiment of this application;
FIG. 11 is a schematic diagram of a cross-section structure of another circuit board assembly according to an embodiment of this application;
FIG. 12 is a schematic diagram of a cross-section structure of another circuit board assembly according to an embodiment of this application;
FIG. 13 is a schematic diagram of a cross-section structure of another circuit board assembly according to an embodiment of this application;
FIG. 14 is a top view of another circuit board assembly according to an embodiment of this application;
FIG. 15 is a schematic diagram of a cross-section structure of another circuit board assembly according to an embodiment of this application;
FIG. 16 is a top view of another circuit board assembly according to an embodiment of this application;
FIG. 17 is a schematic diagram of a cross-section structure of another circuit board assembly according to an embodiment of this application; and
FIG. 18 is a schematic diagram of a structure of an electronic device according to an embodiment of this application.

### DESCRIPTION OF EMBODIMENTS

To make the objectives, technical solutions, and advantages of this application clearer, the following further describes this application in detail with reference to the accompanying drawings.

For ease of understanding of a circuit board assembly provided in embodiments of this application, the following first describes an application scenario of the circuit board assembly

The circuit board assembly provided in embodiments of this application may be applied to a scenario in which a photovoltaic device or a power battery requires power supply transmission and electrical signal transmission.

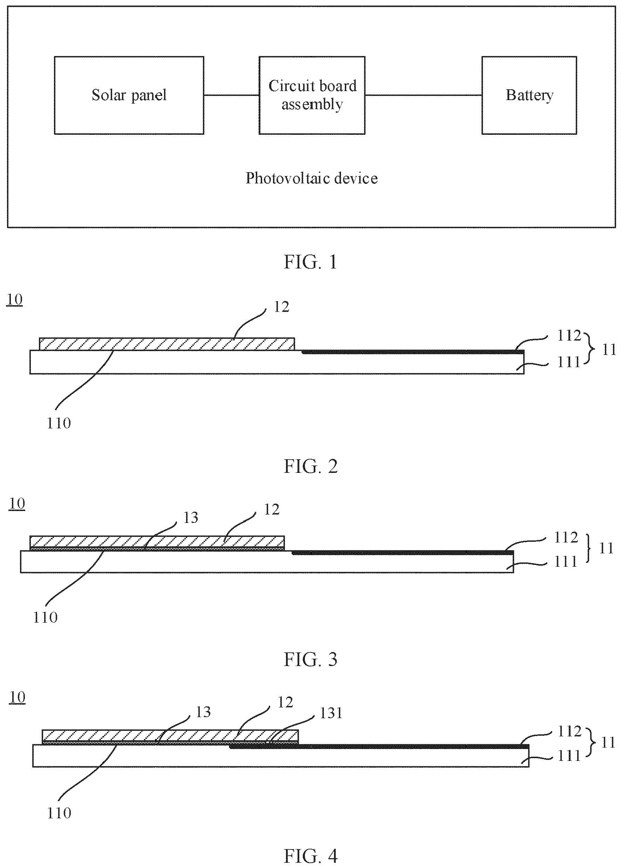

For example, as shown in FIG. 1, a photovoltaic device may generally include a solar panel, a battery, and the like. The solar panel may convert solar energy into electrical energy. The battery is connected to the solar panel, and may store and release the electrical energy generated by the solar panel. The solar panel and the battery may be connected through a circuit board assembly The circuit board assembly may include a circuit board (for example, a printed circuit board) and an electronic component disposed on the circuit board, such as a relay or an inductor. The circuit board is provided with a trace for carrying a current and an electrical signal. The electronic component may be connected to a circuit in the circuit board based on a design requirement, to perform processing such as power conversion on the electrical energy in the solar panel or the battery.

With the continuous development of technologies, efficiency of a solar panel is increased continuously, and operating currents of some electronic components are accordingly increased. Therefore, a circuit board is required to have a current-carrying capability that is sufficiently good to meet a requirement for transmitting a relatively large current.

A current circuit board generally includes an insulating substrate and a conductive trace (which may also be referred to as a copper layer) located on a surface of the insulating substrate. To enable the circuit board to carry a relatively large operating current, two manners are generally used to improve current-carrying performance of the circuit board. One manner is to increase a quantity of conductive traces by increasing a quantity of layers of the circuit board, so that a plurality of conductive traces jointly carry the relatively large operating current. The other manner is to improve a current flow capability by increasing a thickness of the copper layer. However, both of the two manners cause a relatively large thickness of the circuit board, which goes beyond a capability range of current manufacturing and assembly processes of the circuit board. In addition, machining difficulty and costs are significantly increased, which is not conducive to actual application.

Therefore, this application provides a circuit board assembly that may carry a relatively large current and is easy to manufacture.

To make objectives, technical solutions, and advantages of this application clearer, the following further describes this application in detail with reference to the accompanying drawings and specific embodiments.

Terms used in the following embodiments are merely intended to describe specific embodiments, but are not intended to limit this application. Terms "one", "a", and "this" of singular forms used in this specification and the appended claims of this application are also intended to include a form like "one or more", unless otherwise specified in the context clearly. It should be further understood that, in the following embodiments of this application, "at least one" means one, two, or more.

Reference to "one embodiment" described in this specification or the like means that one or more embodiments of this application include a particular feature, structure, or characteristic described in combination with the embodiment. Therefore, in this specification, statements, such as "in an embodiment", "in some embodiments", and "in other embodiments", that appear at different places do not necessarily mean referring to a same embodiment, instead, the statements mean referring to "one or more but not all of the embodiments", unless otherwise emphasized in other ways. Terms "include", "have", and variants of the terms all mean "include but are not limited to", unless otherwise emphasized in other ways.

As shown in FIG. 2, in an example provided in this application, a circuit board assembly 10 may include a circuit board 11 and a conductive plate 12. The circuit board 11 includes a substrate 111 and a conductive trace 112 disposed on the substrate 111. In addition, the circuit board 11 is provided with a first region 110. The conductive plate 12 is fastened in the first region 110, and a current-carrying capacity of the conductive plate 12 is greater than that of the conductive trace 112. During specific application, the conductive plate 12 has a relatively high current-carrying capability, and may be used to carry a relatively large operating current, thereby improving a current-carrying capability of the circuit board assembly 10. A current carried over the conductive plate 12 may be a current, such as a direct current or an alternating current with a relatively large current volume. The conductive trace 112 is mainly used to carry an electrical signal. Certainly, during a specific implementation, the conductive trace 112 may also be used to carry a power supply current, such as a direct current or an alternating current with a relatively small current volume. In the circuit board assembly 10 provided in this embodiment of this application, the conductive plate 12 capable of carrying the relatively large operating current is provided to significantly improve the current-carrying capability of the circuit board assembly 10, so that the circuit board assembly 10 can be applied to a scenario requiring a relatively large current; and the conductive plate 12 and the circuit board 11 are separately manufactured, and then, the conductive plate 12 is disposed in the first region 110 of the circuit board 11 to implement a fastened connection between the conductive plate 12 and the circuit board 11. Therefore, manufacturing costs and process difficulty are reduced, and low-cost and batch manufacturing is implemented.

It should be noted that the first region 110 of the circuit board 11 means a surface that is of the circuit board 11 and that is used to accommodate the conductive plate 12, where the surface may be a flat surface, a curved surface, or the like. In addition, the first region 110 may be located on an outer surface of the circuit board 11. Alternatively, when the circuit board is a multilayer board, the first region 110 may also be located on a boundary surface between different layers of the circuit board.

In addition, the conductive trace 112 in the circuit board 11 is generally disposed on a surface of the substrate 111, and is covered with a protective layer, to ensure safety of the conductive trace 112 and electrical insulation between the conductive trace 112 and the outside.

During specific configuration, the circuit board 11 may be a printed circuit board (PCB), a flexible circuit board (FPC), or a combination of a printed circuit board and a flexible circuit board. A specific type of the circuit board 11 is not limited in this application. In actual application, the circuit board 11 may be of a common type currently used, and details are not described herein.

In addition, the circuit board 11 may be a single-layer board, or a multilayer board. In actual application, a quantity of layers of the circuit board 11 may be properly configured based on an actual requirement. This is not limited in this application.

As shown in FIG. 2, in the example provided in this application, the circuit board 11 is a single-layer board. , the circuit board 11 includes the substrate 111 and the conductive trace 112 disposed on the surface of the substrate 111. A material of the substrate 111 may include resin, glass fiber, aluminum, copper, or the like. It may be understood that, compared with a substrate 111 made of the resin or the glass fiber, a substrate 111 made of aluminum or copper may have better thermal conductivity. Therefore, heat dissipation performance of the circuit board 11 can be improved.

It may be understood that, when the substrate 111 is made of a material that has good heat dissipation performance and a specific electrical conductivity, such as aluminum or copper, an insulation layer may be disposed between the substrate 111 and the conductive trace 112. In addition, if there is no requirement for a conductive connection between the conductive plate 12 and the substrate 111, an insulation layer may be disposed between the conductive plate 12 and the substrate 111, to ensure insulation between the conductive plate 12 and the substrate 111.

In actual application, a material of the substrate 111 may be properly configured based on an actual requirement. This is not limited in this application.

The conductive trace 112 may be disposed on a first surface (for example, an upper surface in FIG. 2) of the substrate 111, or may be disposed on both an upper surface and a lower surface of the substrate 111. The conductive trace 112 may be manufactured by using a current manufacturing process of a printed circuit board or a flexible circuit board, and details are not described herein. Alternatively, the circuit board 11 may be of a common type currently used, and may be manufactured by using a currently conventional manufacturing process.

The conductive plate 12 may be a plate body structure made of a material with relatively good electrical conductivity, such as copper or aluminum. A thickness of the conductive plate 12 may be 0.3 mm or greater than 0.3 mm, to ensure a current-carrying capability of the conductive plate 12. A shape of the conductive plate 12 may be a regular shape such as a strip, a circle, or a rectangle, or may be another irregular shape. A specific shape of the conductive plate 12 is not limited in this application.

During manufacturing, the conductive plate 12 may be manufactured into a required shape by using a process such as stamping or cutting. Then, the conductive plate 12 obtained through shaping may be disposed on a surface of the circuit board 11, so that the circuit board 11 and the conductive plate 12 are manufactured into an integrated structure. Alternatively, the copper plate (or a plate body made of another material) may be first disposed on a surface of the circuit board 11. Then, the copper plate may be processed by using a process such as depth control milling, so that the copper plate can be manufactured into a required shape. The depth control milling means that, when a printed circuit board is manufactured, a groove structure that meets a requirement is obtained through milling by controlling a cutting depth of a computer numerical control (CNC) machine tool at a specified position of the printed circuit board. In other words, an entire copper plate located on the circuit board 11 may be processed by using the depth control milling process, and the entire copper plate may be separated into a plurality of different plate bodies. Alternatively, an outer profile of an entire copper plate is processed to prepare a required shape profile.

In addition, in some examples, the circuit board assembly 10 may also be manufactured by using a process for manufacturing a metal base circuit board. The conductive plate 12 may be understood as a metal base in a metal base circuit board. The substrate 111 in the circuit board 11 may be understood as a structure for carrying the conductive trace 112 and maintaining electrical insulation between the conductive trace 112 and the conductive plate 12.

Certainly, in an actual manufacturing process, the circuit board 11 may be manufactured by using a proper machining process and sequence. This is not limited in this application.

During specific application, the circuit board 11 and the conductive plate 12 may be connected in various manners.

For example, as shown in FIG. 3, in an example provided in this application, the circuit board 11 may be connected to the conductive plate 12 in a press-fitting manner.

, the conductive plate 12 may be fastened in the first region 110 of the circuit board 11 through a dielectric layer 13. A material of the dielectric layer 13 may include a material such as polypropylene or a polymer thereof. During manufacturing, the material of the dielectric layer 13 may be coated in the first region 110 of the circuit board 11. Then, the prepared and formed conductive plate 12 is attached to a surface of the dielectric layer 13, and the conductive plate 12 and the circuit board 11 are press-fitted and fastened through a hot-pressing device, to implement a reliable connection between the conductive plate 12 and the circuit board 11. Certainly, during preparation, the fastened connection between the conductive plate 12 and the circuit board 11 may alternatively be implemented by using another process or sequence. A preparation process of the circuit board assembly 10 is not limited in this application.

In some implementations, the conductive plate 12 may be electrically connected to the conductive trace 112 in the circuit board 11.

For example, as shown in FIG. 4, in an example provided in this application, the circuit board assembly 10 is provided with a plated through hole 131 that a plated through hole 131 that passes through the dielectric layer in a thickness direction . A conductive layer in the plated through hole 131 is electrically connected to the conductive trace 112 in the circuit board 11, and is also connected to the conductive plate 12, so that the electrical connection between the conductive trace 112 and the conductive plate 12 may be implemented.

Certainly, in another example, when the conductive trace 112 is located on a lower surface of the substrate 111, a corresponding structure such as a plated through hole may also be disposed in the circuit board 11, to implement the electrical connection between the conductive trace 112 and the conductive plate 12. Details are not described herein again.

In addition, in some examples, the conductive trace 112 and the conductive plate 12 may be electrically connected in another manner.

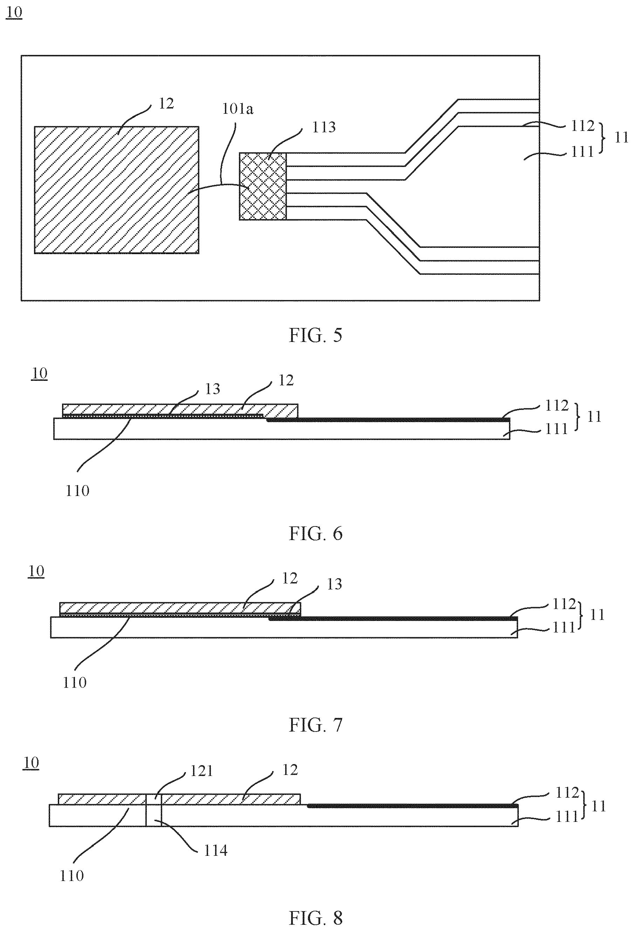

For example, as shown in FIG. 5, in an example provided in this application, the conductive trace 112 includes a pad 113. During a specific implementation, a metal wire 101a or a conductive member of another type may be used to implement an electrical connection between the conductive plate 12 and the pad 113.

Alternatively, as shown in FIG. 6, the conductive trace 112 in the circuit board 11 may extend to the first region 110. , the pad 113 of the conductive trace 112 may be exposed in the first region 110. When the conductive plate 12 is disposed in the first region 110, a surface of the conductive plate 12 may be attached to the pad 113, to implement the electrical connection between the conductive plate 12 and the conductive trace 112.

Alternatively, as shown in FIG. 7, the electrical connection between the conductive plate 12 and the pad 113 may be implemented through the dielectric layer 13. , the material of the dielectric layer 13 may be a conductive composite material composed of polypropylene and a conductive filler, so that the dielectric layer 13 has relatively good electrical conductive performance. In other words, the electrical connection between the conductive plate 12 and the pad 113 may be implemented through the dielectric layer 13. In addition, the fastened connection between the conductive plate 12 and the circuit board 11 may be implemented through the dielectric layer 13. This helps simplify a preparation procedure.

Certainly, in another example, the material of the dielectric layer 13 may also be solder, or the like, and the dielectric layer 13 may also be used to implement the fastened connection and a conductive connection between the conductive plate 12 and the circuit board 11. In actual application, the material and a machining process of the dielectric layer 13 may be properly selected based on an actual requirement. Details are not described herein.

In addition, the conductive plate 12 and the circuit board 11 may alternatively be connected in another manner.

For example, as shown in FIG. 8, in an example provided in this application, the conductive plate 12 is provided with a first through hole 121, and the circuit board 11 is provided with a second through hole 114. The first through hole 121 communicates with the second through hole 114. The first through hole 121 and the second through hole 114 each are filled with solder (not shown in FIG. 8), so that the fastened connection between the conductive plate 12 and the circuit board 11 can be implemented.

The first through hole 121 communicates with the second through hole 114, so that the solder filled in the first through hole 121 and the second through hole 114 is continuous. Therefore, the fastened connection between the conductive plate 12 and the circuit board 11 can be implemented.

In the example provided in FIG. 8, the first through hole 121 and the second through hole 114 are disposed coaxially, and hole diameters of the first through hole 121 and the second through hole 114 are roughly the same. However, in another example, the first through hole 121 and the second through hole 114 may be disposed on different axes, and hole diameters of the first through hole 121 and the second through hole 114 may be different. This is not limited in this application.

In addition, in another example, two or more first through holes 121 may be provided. Correspondingly, two or more second through holes 114 may be provided, and details are not described herein.

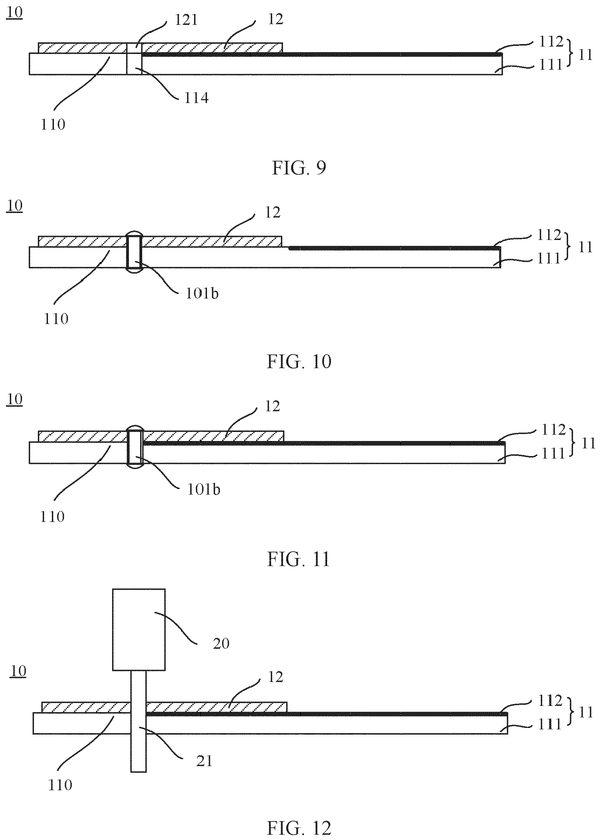

In addition, as shown in FIG. 9, in some implementations, the conductive trace 112 in the circuit board 11 may extend to the second through hole 114, so that the electrical connection between the conductive plate 12 and the conductive trace 112 can be implemented through the solder.

Alternatively, the conductive plate 12 may be connected to the circuit board 11 through an additional connecting piece.

For example, as shown in FIG. 10, in an example provided in this application, the connecting piece is a rivet 101b. The rivet 101b passes through the first through hole 121 and the second through hole 114. Moreover, the rivet 101b is fastened to the first through hole 121 and the second through hole 114, so that the fastened connection between the conductive plate 12 and the circuit board 11 can be implemented.

In a specific application, the rivet 101b may be made of an insulation material, or a conductive material.

As shown in FIG. 11, when the rivet 101b is made of a conductive material, the conductive trace 112 in the circuit board 11 may extend to the second through hole 114. The electrical connection between the conductive plate 12 and the conductive trace 112 may be implemented through the rivet.

Certainly, in another example, the rivet 101b may be replaced with a connecting piece such as a screw. A specific material and a type of the connecting piece are not limited in this application.

Alternatively, as shown in FIG. 12, in another example provided in this application, the conductive plate 12 and the circuit board 11 may be connected through a pin of an electronic component 20.

, the pin 21 of the electronic component 20 passes through the first through hole 121 and the second through hole 114, and the pin 21 is fastened to the first through hole 121 and the second through hole 114. A diameter of the pin 21 may be slightly greater than those of the first through hole 121 and the second through hole 114, so that the pin 21 can be stably clamped into the first through hole 121 and the second through hole 114, thereby implementing the fastened connection between the conductive plate 12 and the circuit board 11.

Alternatively, in some examples, the conductive plate 12 and the pin 21 may be welded through solder, to improve stability of a connection between the pin 21 and the conductive plate 12. The circuit board 11 and the pin 21 may be welded through the solder, to improve connection stability between the pin 21 and the circuit board 11.

In addition, in some examples, the conductive trace 112 in the circuit board 11 may extend to the second through hole 114, so that the electrical connection between the conductive trace 112 and the conductive plate 12 can be implemented.

In addition, in some examples, an inner wall of the second through hole 114 may be plated, to improve electrical connection effect between the conductive trace 112 and the conductive plate 12.

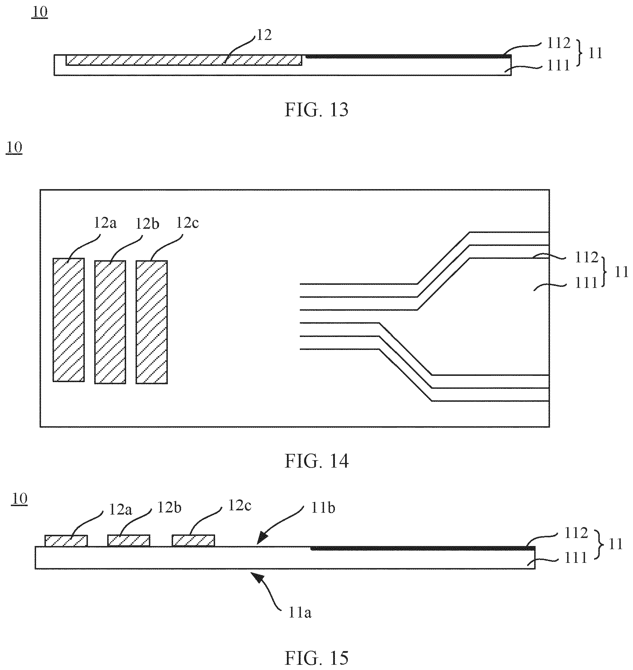

Alternatively, as shown in FIG. 13, the fastened connection between the conductive plate 12 and the circuit board 11 may alternatively be implemented through embedding.

, a groove (not shown in the figure) is disposed on the circuit board 11, a bottom wall of the groove may be the first region, and the conductive plate 12 is embedded and fastened in the groove. An edge of the conductive plate 12 may be embedded tight on an inner wall of the groove, so that the conductive plate 12 can be firmly fastened in the groove.

The conductive plate 12 is disposed in the groove, so that a thickness of the circuit board assembly 10 can be effectively reduced. This is conducive to implementing a light and thin design of the circuit board assembly 10, and enables the circuit board assembly 10 to be applied to a scenario with a specific requirement on a thickness of a board layout.

During specific configuration, a depth size of the groove may be the same as or different from a thickness of the conductive plate 12.

For example, as shown in FIG. 13, in the example provided in this application, the thickness of the conductive plate 12 is roughly the same as the depth size of the groove. After the conductive plate 12 is disposed in the groove, the surfaces of the conductive plate 12 and the circuit board 11 are roughly aligned. This may effectively prevent the conductive plate 12 from being adversely affected, for example, from being scraped by a foreign object.

Certainly, in another example, the thickness of the conductive plate 12 may alternatively be greater than or less than the depth size of the groove. This is not limited in this application.

When the conductive plate 12 is configured, the thickness of the conductive plate 12 may be greater than or equal to 0.3 mm, so that the conductive plate 12 has a relatively good current-carrying capability. In actual application, dimensions such as the thickness, an area, and a shape of the conductive plate 12 may be properly set based on an application requirement. This is not limited in this application.

In addition, during specific configuration, the conductive plate 12 may be an entire plate body, or may include a plurality of mutually isolated sub-plate bodies.

For example, as shown in FIG. 14, in an example provided in this application, the conductive plate 12 includes three sub-plate bodies. The three sub-plate bodies are respectively a sub-plate body 12a, a sub-plate body 12b, and a sub-plate body 12c.

As shown in FIG. 15, the circuit board 11 has a first surface 11a and a second surface 11b that are disposed opposite to each other, and the three sub-plate bodies are all disposed on the first surface 11a of the circuit board 11. In other words, the first region in which the conductive plate 12 is disposed may be located on the first surface 11a.

In another example, the three sub-plate bodies may also be all disposed on the second surface 11b. Alternatively, some sub-plate bodies may be disposed on the first surface 11a, and remaining sub-plate bodies may be disposed on the second surface 11b.

During specific application, a quantity, shapes, and arrangement positions of the sub-plate bodies may be configured properly based on an actual requirement.

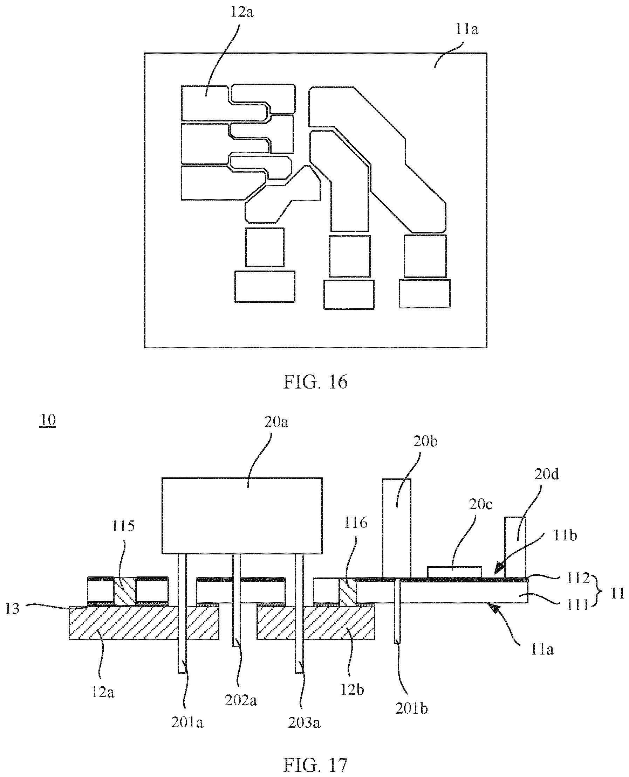

For example, as shown in FIG. 16, in another example provided in this application, the conductive plate 12 includes 13 sub-plate bodies (only one sub-plate body 12a is shown in the figure), and the 13 sub-plate bodies are disposed on the first surface 11a of the circuit board 11 based on preset positions and shapes, to meet a preset demand for electrical conductivity.

When the circuit board component 10 is used, various components of different types may be provided based on an actual requirement.

As shown in FIG. 17, in an example provided in this application, four electronic components are disposed in the circuit board assembly 10, and are respectively an electronic component 20a, an electronic component 20b, an electronic component 20c, and an electronic component 20d. The following uses an example in which the electronic component 20a is a relay, the electronic component 20b is a capacitor, the electronic component 20c is a controller, and the electronic component 20d is a connector for description.

The electronic component 20a has three pins: a pin 201a, a pin 202a, and a pin 203a. The pin 201a is connected to the sub-plate body 12a, the pin 203a is connected to the sub-plate body 12b, and the pin 202a is connected to the circuit board 11.

The pin 201a and the pin 203a are power pins for circulating a relatively large current flows, and the pin 202a is a signal pin or a driver pin. The controller 20c may be connected to the pin 202a through the conductive trace 112 in the circuit board 11, to control a connection and disconnection between the pin 201a and the pin 203a, thereby controlling a connection and disconnection of a circuit between the sub-plate body 12a and the sub-plate body 12b.

In addition, the electronic component 20b is disposed on the circuit board 11 through the pin 201b. The circuit board 11 is provided with a jack (not shown in the figure) in which the pin 201b of the electronic component 20b is inserted, and the jack is located outside the first region 110. In other words, the sub-plate body 12a or the sub-plate body 12b does not cover the jack, to prevent the sub-plate body 12a or the sub-plate body 12b from blocking the jack.

It may be understood that, in another example, the electronic component 20a may also be an inductor or the like. A specific type of the electronic component 20a is not limited in this application.

During manufacturing, the electronic component 20a may be disposed in the circuit board assembly 10 by using a process such as surface mounting, wave soldering, or laser soldering. An assembly process of the component is not limited in this application.

In addition, a functional circuit with functions such as sampling, protection, or filtering may be disposed in the conductive trace 112 of the circuit board 11. The sub-plate body 12a may be connected to the conductive trace 112 in the circuit board 11 through a structure such as a via hole 115 disposed in the circuit board 11. The sub-plate body 12b may be connected to the conductive trace 112 in the circuit board 11 through a structure such as a via hole 116 disposed in the circuit board 11.

In addition, as shown in FIG. 17, in the example provided in this application, during specific configuration, the conductive plate 12 and the electronic component may be located on different surfaces of the circuit board 11. In other words, both the sub-plate body 12a and the sub-plate body 12b are disposed on the first surface 11a (a lower surface in the figure) of the circuit board 11, and all the electronic components are disposed on the second surface 11b (an upper surface in the figure) on the circuit board 11. It may be understood that, in some examples, the sub-plate body 12a and the sub-plate body 12b may alternatively be located on different surfaces of the circuit board 11. In addition, the electronic component and the sub-plate body 12a or the sub-plate body 12b may alternatively be located on the same surface of the circuit board 11.

During specific application, the circuit board assembly 10 can be applied to various electronic devices of different types, and can be configured to implement transmission of an electrical signal and a relatively large current.

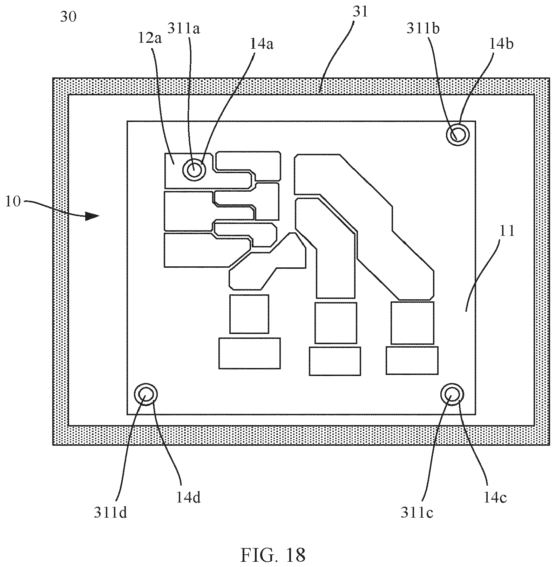

As shown in FIG. 18, an embodiment of this application further provides an electronic device 30, including a housing 31 and the circuit board assembly 10. The circuit board assembly 10 is fastened in the housing 31.

During specific configuration, the circuit board 11 in the circuit board assembly 10 may be fastened to the housing.

For example, a mounting hole may be disposed in the circuit board 11, and a fastening column may be disposed in the housing. A fastened connection between the circuit board 11 and the housing 31 may be implemented by inserting the fastening column into the mounting hole.

, in an example provided in this application, there are four mounting holes: a mounting hole 14a, a mounting hole 14b, a mounting hole 14c, and a mounting hole 14d. There are four fastening columns, which are respectively a fastening column 31 1a, a fastening column 311b, a fastening column 311c, and a fastening column 311d. The fastening column 311a is inserted into the mounting hole 14a, the fastening column 311b is inserted into the mounting hole 14b, the fastening column 311c is inserted into the mounting hole 14c, and the fastening column 311d is inserted into the mounting hole 14d. Therefore, the fastened connection between the housing 31 and the circuit board assembly 10 is implemented, to prevent the circuit board assembly 10 from generating an adverse situation such as shaking in the housing.

In addition, in the example provided in FIG. 18, the mounting hole 14a passes through the sub-plate body 12a. During configuration, a fastening column 311a may be made of a conductive material, so that an electrical connection between the sub-body 12a and the housing 31 can be implemented.

In actual application, the sub-plate body 12a may be used as a grounding structure of the circuit board assembly 10. After the sub-plate body 12a is electrically connected to the housing 31, a grounding connection of the circuit board assembly 10 may be implemented through the housing 31.

The housing 31 may be made of a conductive material, or a part of a region of the housing 31 may be made of a conductive material, and the other part of the region may be made of an insulation material. A specific material of the housing 31 is not limited in this application.

During actual application, the electronic device may be a photovoltaic device, an energy storage device, a charging pile, or the like. A specific type of the electronic device is not limited in this application. Alternatively, it may be understood that the circuit board assembly 10 provided in embodiment of this application can be applied to various electronic devices of different types.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A circuit board assembly, comprising:
a conductive plate, configured to carry a current; and
a circuit board, comprising a substrate and a conductive trace, wherein the conductive trace is disposed on the substrate; and
the conductive plate is fastened in a first region of the circuit board, and a current-carrying capacity of the conductive plate is greater than that of the conductive trace.

2. The circuit board assembly according to claim 1, wherein the circuit board has a first surface and a second surface that are disposed opposite to each other; and
the first region is a portion of the first surface or of the second surface.

3. The circuit board assembly according to claim 1 or 2, wherein the conductive plate is fastened in the first region through a dielectric layer.

4. The circuit board assembly according to claim 3, wherein the circuit board assembly is provided with a plated through hole, the plated through hole passes through the dielectric layer, and the plated through hole is electrically connected to the conductive trace and the conductive plate.

5. The circuit board assembly according to claim 3, wherein the dielectric layer comprises a conductive material, the conductive trace extends to the first region, and the dielectric layer is electrically connected to the conductive plate and the conductive trace.

6. The circuit board assembly according to claim 1, wherein the circuit board is provided with a groove, the conductive plate is embedded in the groove, and the first region is a bottom of the groove.

7. The circuit board assembly according to any one of claims 1 to 6, wherein the conductive plate is provided with a first through hole, the circuit board is provided with a second through hole, and the first through hole communicates with the second through hole.

8. The circuit board assembly according to claim 7, wherein solder is provided in the first through hole and the second through hole.

9. The circuit board assembly according to claim 7, wherein the circuit board assembly comprises a connecting piece, and the connecting piece passes through the first through hole and the second through hole and is fastened.

10. The circuit board assembly according to any one of claims 1 to 9, wherein the circuit board assembly comprises an electronic component, and the electronic component is electrically connected to the conductive plate and the conductive trace.

11. The circuit board assembly according to claim 10, wherein the electronic component comprises a pin, and the pin passes through the conductive plate and the circuit board and is fastened.

12. The circuit board assembly according to any one of claims 1 to 11, wherein the conductive plate comprises a plurality of sub-plate bodies, and the plurality of sub-plate bodies are spaced apart from each other.

13. The circuit board assembly according to any one of claims 1 to 12, wherein a thickness of the conductive plate is greater than or equal to 0.3 mm.

14. The circuit board assembly according to any one of claims 1 to 13, wherein the circuit board is provided with a jack, and the jack is located outside the first region.

15. An electronic device, comprising a housing and the circuit board assembly according to any one of claims 1 to 14, wherein the circuit board assembly is fastened in the housing.
